# EUROPEAN PATENT APPLICATION

(11) **EP 4 210 451 A1**
(43) Date of publication of application: **12.07.2023**
(21) Application number: 22217202.5
(22) Date of filing: 29.12.2022
(51) Int. Cl.: H10K 50/813, H10K 50/822, H10K 59/124, H10K 50/858

(54) **DISPLAY APPARATUS**

(30) Priority: 30.12.2021 KR 20210192391
(71) Applicant: LG Display Co., Ltd., SEOUL, 07336 (KR)
(72) Inventor: Kim, Bongjun, 10845 Gyeonggi-do (KR)
(74) Representative: Ter Meer Steinmeister & Partner

(57) **Abstract**

A display apparatus includes a substrate including a plurality of sub-pixel areas; an overcoat layer disposed on the substrate and having a plurality of concave portions disposed in each of the plurality of sub-pixel areas; and a bank layer disposed on the overcoat layer and having openings defined therein so as to define a light-emitting area of each of the plurality of sub-pixel areas. In this regard, the plurality of sub-pixel areas include a first sub-pixel area having a first light-emitting area, wherein the overcoat layer has a pair of first flat areas in the first light-emitting area, wherein the concave portions are absent in each of the first flat areas.

## Description

### BACKGROUND

### Field

The present disclosure relates to a display apparatus, and more particularly, to a display apparatus including a micro lens array.

### Description of Related Art

As society enters full-fledged information age, various display apparatuses that process and display a large amount of information have been developed. There are various types of display apparatuses that display images, such as a liquid crystal display apparatus (LCD), an organic light-emitting display apparatus (OLED), and a quantum dot display apparatus (QD).

Recently, an organic light-emitting display apparatus being spotlighted as a display apparatus includes an organic light-emitting diode (OLED) which emits light by itself. Thus, the apparatus has fast response speed, high contrast ratio, luminous efficiency, and wide viewing angle.

While the light emitted from an organic light-emitting layer of the organic light-emitting display apparatus travels through various components of the organic light-emitting display apparatus and is emitted to an outside, a large portion thereof may be lost. Thus, a portion of the light emitted to the outside out of the organic light-emitting display apparatus accounts for only about 20% of the light emitted from the organic light-emitting layer.

Therefore, recently, in order to improve light extraction efficiency of the organic light-emitting display apparatus, a scheme of forming a micro lens array inside a display panel of the organic light-emitting display apparatus has been proposed.

### SUMMARY

In a manufacturing process of the organic light-emitting display apparatus, a size of each of openings of a bank layer is managed to be within a predefined range. Since the openings of the bank layer define each of light-emitting areas, the size of each of the openings of the bank layer must be managed to be within a predefined target range such that light-emitting characteristics of the organic light-emitting display apparatuses manufactured on a manufacturing line are uniform.

In particular, if in an organic light-emitting display apparatus having a micro lens array formed inside the display panel the size of some or each of the openings of the bank layer is smaller than the predefined target range, the number of micro lenses contributing to light extraction decreases and thus the light extraction efficiency decreases.

To measure the sizes of the openings of the bank layer, an optical image of the bank layer is photographed after the bank layer has been patterned. A gray level at each of both opposing sidewalls of the opening of the bank layer is extracted from the photographed optical image, and the size of the opening is measured based on the gray level and a predefined critical value.

When a micro lens array is formed inside the display panel of the organic light-emitting display apparatus, specifically on an overcoat layer disposed below the bank layer, the gray level at each of both opposing sidewalls of the opening extracted from the photographed optical images is distorted and thus the size of the opening of the bank layer may not be measured or at least not measured exactly enough.

Accordingly, the inventors of the present disclosure have invented a display apparatus in which a size of each of openings of a bank layer may be accurately measured even if a micro lens array is formed on an overcoat layer inside a display panel.

A purpose of an embodiment of the present disclosure is to provide a display apparatus in which the size of the opening in the bank layer or a distance between the openings may be measured, thereby preventing a decrease in light extraction efficiency due to uneven area sizes of the opening.

Purposes of the present disclosure are not limited to the above-mentioned purpose. Other purposes and advantages of the present disclosure that are not mentioned may be understood based on following descriptions, and may be more clearly understood based on embodiments of the present disclosure.

The object is solved by the features of the independent claims. Preferred embodiments are given in the dependent claims.

A display apparatus comprises a substrate including a plurality of sub-pixel areas; an overcoat layer disposed on the substrate and having a plurality of concave portions disposed in each of the plurality of sub-pixel areas; and a bank layer disposed on the overcoat layer and having openings defined therein so as to define a light-emitting area of each of the plurality of sub-pixel areas. In this regard, the plurality of sub-pixel areas include a first sub-pixel area having a first light-emitting area, wherein the overcoat layer has a pair of first flat areas in the first light-emitting area, wherein the concave portions are absent in each of the first flat areas.

In one or more embodiments, the first flat areas may be spaced apart from each other.

In one or more embodiments, the first flat areas may be spaced apart from each other in a first direction in which a gate line extends and/or may be respectively disposed at both opposing sides of the first light-emitting area.

In one or more embodiments, an edge of the bank layer defining the first light emitting area and extending in a second direction is overlapping both the first flat area and the concave portions.

The pair of first flat areas might be also or alternatively located at the upper and lower edge of the opening to more precisely determine the vertical dimension of the opening.

In one or more embodiments, each of the first flat areas may extend out of the first light-emitting area so as to overlap a portion of the bank layer.

In one or more embodiments, each of the first flat areas may be located evenly inside and outside of the opening.

In one or more embodiments, each of the first flat areas may have the same area size

In one or more embodiments, each of the first flat areas may have an area size greater than an area size of one concave portion, preferably equal to or greater than 4 times of an area size of one concave portion.

In one or more embodiments, the plurality of sub-pixel areas may include a second sub-pixel area spaced apart from the first sub-pixel area and having a second light-emitting area.

In one or more embodiments, the overcoat layer may have one second flat area in the second light-emitting area, wherein the concave portions are absent in the second flat area.

In one or more embodiments, the second flat area may extend out of the second light-emitting area so as to overlap a portion of the bank layer.

In one or more embodiments, the second flat area may have an area size greater than an area size of one concave portion, preferably equal to or greater than 4 times of an area size of one concave portion.

In one or more embodiments, the first flat areas and the second flat area may be located at the same line extending in a first direction in which a gate line extends.

In one or more embodiments, another sub-pixel area is located between the first sub-pixel area and the second sub-pixel area, and/or wherein the another sub-pixel area does not have any flat area in a light emitting area and/or the light emitting area of the another sub-pixel area is fully covered by concave portions.

The specific details of other embodiments are included in the detailed description and drawings.

According to an embodiment of the present disclosure, the flat areas in which the concave portions constituting the micro lens array are not formed are disposed at the overcoat layer so as to overlap the sidewalls of the opening of the bank layer, respectively. Thus, a gray level at each of the sidewalls of the opening of the bank layer in the photographed optical image is not distorted. Thus, the size of the opening of the bank layer or the distance between the openings may be measured without error.

The first sub pixel may be a red sub pixel and the second sub pixel may the white sub pixel.

Preferably, a blue or green sub pixel might be disposed between the red and the white sub pixel.

The red sub pixel and the white sub pixel might have a larger opening size compared to the blue or green sub pixel.

The red sub pixel and the white sub pixel might have a same size, wherein the blue and green sub pixel also have a same size being smaller than the area size of the red and white sub pixel.

According to an embodiment of the present disclosure, the first and second flat areas in which the concave portions are not formed may be disposed at the upper surface of the overcoat layer facing the bank layer such that the size of the opening in the bank layer or the distance between the openings may be measured. Thus, the size of the opening in the bank layer or the distance between the openings or the distance between edges of adjacent openings may be managed to be within a predefined target range. This may prevent decrease in the light extraction efficiency of the display apparatus. In case a size of an opening is detected as being too small, the opening will be manually enlarged by reworking to have an opening within the tolerances of the area sizes.

Effects of the present disclosure are not limited to the above-mentioned effects, and other effects as not mentioned will be clearly understood by those skilled in the art from following descriptions.

### BRIEF DESCRIPTION OF DRAWINGS

FIG. 1 is a plan view showing one pixel area of an organic light-emitting display apparatus according to an embodiment of the present disclosure.
FIG. 2 is a cross-sectional view showing a cross section of the organic light-emitting display apparatus cut along a I-I' cut line in FIG. 1.
FIG. 3 is a plan view showing two sub-pixel areas of an organic light-emitting display apparatus according to an embodiment of the present disclosure.
FIG. 4 shows forms of first and second flat areas of embodiments of the present disclosure.

### DETAILED DESCRIPTIONS

Advantages and features of the present disclosure, and a method of achieving the advantages and features will become apparent with reference to embodiments described later in detail together with the accompanying drawings. However, the present disclosure is not limited to embodiments as disclosed below, but may be implemented in various different forms. Thus, these embodiments are set forth only to make the present disclosure complete, and to completely inform the scope of the present disclosure to those of ordinary skill in the technical field to which the present disclosure belongs.

A shape, a size, a ratio, an angle, a number, etc. disclosed in the drawings for describing the embodiments of the present disclosure are illustrative, and the present disclosure is not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "comprising", "include", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of" when preceding a list of elements may modify an entirety of list of elements and may not modify the individual elements of the list. In interpretation of numerical values, an error or tolerance therein may occur even when there is no explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

Further, as used herein, when a layer, film, region, plate, or the like may be disposed "on" or "on a top" of another layer, film, region, plate, or the like, the former may directly contact the latter or still another layer, film, region, plate, or the like may be disposed between the former and the latter. As used herein, when a layer, film, region, plate, or the like is directly disposed "on" or "on a top" of another layer, film, region, plate, or the like, the former directly contacts the latter and still another layer, film, region, plate, or the like is not disposed between the former and the latter. Further, as used herein, when a layer, film, region, plate, or the like may be disposed "below" or "under" another layer, film, region, plate, or the like, the former may directly contact the latter or still another layer, film, region, plate, or the like may be disposed between the former and the latter. As used herein, when a layer, film, region, plate, or the like is directly disposed "below" or "under" another layer, film, region, plate, or the like, the former directly contacts the latter and still another layer, film, region, plate, or the like is not disposed between the former and the latter.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

In interpreting a numerical value, the value is interpreted as including an error range unless there is separate explicit description thereof.

The features of the various embodiments of the present disclosure may be partially or entirely combined with each other, and may be technically associated with each other or operate with each other. The embodiments may be implemented independently of each other and may be implemented together in an association relationship.

In descriptions of temporal relationships, for example, temporal precedent relationships between two events such as "after", "subsequent to", "before", etc., another event may occur therebetween unless "directly after", "directly subsequent" or "directly before" is indicated.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, a display apparatus according to an embodiment of the present disclosure will be described in detail with reference to the accompanying drawings.

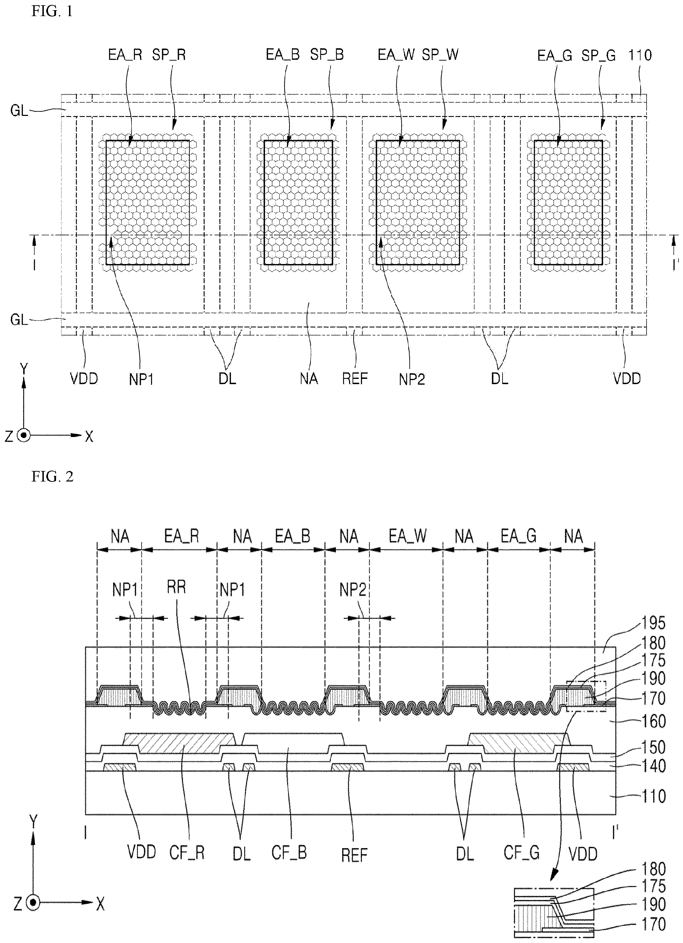

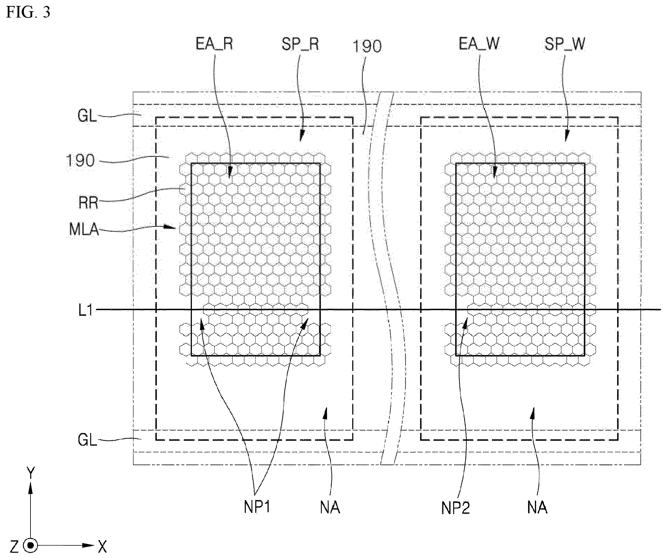

FIG. 1 is a plan view showing one pixel area of an organic light-emitting display apparatus according to an embodiment of the present disclosure. FIG. 2 is a cross-sectional view showing a cross section of the organic light-emitting display apparatus cut along a I-I' cut line in FIG. 1. FIG. 3 is a plan view showing two sub-pixel areas of an organic light-emitting display apparatus according to an embodiment of the present disclosure.

Referring to FIG. 1 and FIG. 3, signal lines including gate lines GL, data lines DL, reference lines REF, and driving voltage lines VDD are disposed on the substrate 110. The gate line GL is arranged to intersect the data line DL, the reference line REF and the driving voltage line VDD.

According to this embodiment, on the substrate 110, a red sub-pixel area SP_R, a blue sub-pixel area SP_B, a white sub-pixel area SP_W, and a green sub-pixel area SP_G may be defined by the matrix defined by the above-described signal lines.

For example, each of the red sub-pixel area SP_R and the green sub-pixel area SP_G may be defined by two gate lines GL extending parallel to each other in horizontal or X-axis direction, and a driving voltage line VDD and a data line DL intersecting the gate lines and extending in vertical or Y-axis direction. Further, each of the white sub-pixel area SP_W and the blue sub-pixel area SP_B may be defined by the two gate lines GL extending parallel to each other in horizontal or X-axis direction, and a data line DL and a reference line REF intersecting the gate lines and extending in vertical or Y-axis direction. Each of the red sub-pixel area SP_R and the white sub-pixel area SP_W may have a larger area size than that of each of the blue sub-pixel area SP_B and the green sub-pixel area SP_G. An arrangement order of the sub-pixel areas, and types and the number of the signal lines extending between the sub-pixel areas may be modified as necessary. A size of each of the sub-pixel areas may also be changed. The red sub-pixel area SP_R and the white sub-pixel area SP_W may have the same area and also the same light-emitting area. The blue sub-pixel area SP_B and the green sub-pixel area SP_G may have the same area and also the light-emitting area.

The red sub-pixel area SP_R, the blue sub-pixel area SP_B, the white sub-pixel area SP_W and the green sub-pixel area SP_G defined on the substrate 110 may include a red light-emitting area EA_R, a blue light-emitting area EA_B, a white light-emitting area EA_W and a green light-emitting area EA_G, respectively. Areas other than the red light-emitting area EA_R, the blue light-emitting area EA_B, the white light-emitting area EA_W, and the green light-emitting area EA_G may belong to a non-light-emitting area NA. In this regard, the red light-emitting area EA_R, the blue light-emitting area EA_B, the white light-emitting area EA_W, and the green light-emitting area EA_G may not be covered with the bank layer 190. That is, the remaining areas excluding the red light-emitting area EA_R, the blue light-emitting area EA_B, the white light-emitting area EA_W, and the green light-emitting area EA_G, that is, the non-light-emitting area NA may be covered with the bank layer 190. Each of the red light-emitting area EA_R and the white light-emitting area EA_W may have a larger area size than that of each of the blue light-emitting area EA_B and the green light-emitting area EA_G.

A plurality of concave portions RR may be disposed in each of the sub-pixel areas SP_R, SP_B, SP_W, and SP_G. The plurality of concave portions RR may be regularly arranged to constitute a micro lens array MLA. A concave portion RR may be a micro lens. The plurality of concave portions RR may be arranged in, for example, a honeycomb shape to constitute the micro lens array MLA. The plurality of concave portions RR may be arranged in each of a plurality of rows adjacent to each other. The plurality of concave portions RR may also be disposed in each of the light-emitting areas EA_R, EA_B, EA_W and EA_G and in the non-light-emitting area NA adjacent to each of the light-emitting areas. In the concave portions of two adjacent rows, a partial area of at least one concave portion among the outermost concave portions may not be covered with the bank layer 190.

The number of the concave portions RR in each of the sub-pixel areas SP_R,SP_B, SP_W, and SP_G is not limited to that shown in FIGS. 1 and 3. The number of the concave portions RR may be larger than the number of the concave portions RR as shown in the drawings. Further, the number of the concave portions RR disposed in the non-light-emitting area NA is not limited to that shown in FIGS. 1 and 3. The number of the concave portions RR disposed in the non-light-emitting area NA may be larger than that as shown in the drawings.

However, the number of concave portions RR disposed in the non-light-emitting area NA may be smaller than the number of concave portions RR disposed in the light-emitting area.

A pair of first flat areas NP1 may be disposed in the red sub-pixel area SP_R, and a second flat area NP2 may be disposed in the white sub-pixel area SP_W. Each of the first flat area NP1 and the second flat area NP2 may refer to an area in which the concave portions RR are not formed.

The first flat area NP1 may be disposed in the red light-emitting area EA_R and may extend out of the red light-emitting area EA_R, that is, to the non-light-emitting area NA. The second flat area NP2 may be disposed in the white light-emitting area EA_W and may extend out of the white light-emitting area EA_W, that is, to the non-light-emitting area NA. In other words, the first flat area NP1 is disposed across the red light-emitting area EA_R and the non-light-emitting area NA, and the second flat area NP2 is disposed across the white light-emitting area EA_W and the non-light-emitting area NA.

The reason why the pair of the first flat areas NP1 is disposed in the red light-emitting area EA_R and the second flat area NP2 is disposed in the white light-emitting area EA_W is that a size of each of the red light-emitting area EA_R and the white light-emitting area EA_W is larger than a size of each of the blue light-emitting area EA_B and the green light-emitting area EA_G, and thus, reduction in the light extraction efficiency of each of the red light-emitting area EA_R and the white light-emitting area EA_W due to the formation of the flat areas NP1 and NP2 in which the concave portions RR are not formed is relatively smaller compared to that in each of the blue light-emitting area EA_B and the green light-emitting area EA_G. As will be described later, the plurality of concave portions RR are regularly arranged to constitute the micro lens array MLA, thereby contributing to improvement of light extraction efficiency of each of the sub-pixel areas. The number of concave portions that may contribute to the improvement of light extraction efficiency may be reduced in a proportional manner to a size of an area by which the flat areas NP1 and NP2 are formed.

The pair of the first flat areas NP1 may be located at the same line. The pair of the first flat areas NP1 may be located at one straight line L1 extending in a first direction (X-axis direction) in which the gate line GL extends. The pair of the first flat areas NP1 and the second flat area NL2 may be located at the same line. The pair of the first flat areas NP1 and the second flat area NL2 may be located at a single straight line L1 extending in the first direction (X-axis direction).

Referring to FIG. 2, on the substrate 110, the data line DL, the reference line REF, the driving voltage line VDD, a buffer layer 140, a passivation layer 150, color filters CF_R, CF_G, and CF_B, an overcoat layer 160, a bank layer 190, first electrodes 170, an organic light-emitting layer 175 and a second electrode 180 may be disposed.

The data line DL, the reference line REF, and the driving voltage line VDD are located on the substrate 110. In addition, the buffer layer 140 covers the data line DL, the reference line REF, and the driving voltage line VDD. The buffer layer 140 may be formed by, for example, stacking a plurality of inorganic layers. For example, the buffer layer 140 may be embodied as a multilayer in which two or more inorganic layers made of a silicon oxide layer (SiOₓ), a silicon nitride layer (SiNₓ), and a silicon oxynitride layer (SiON) are stacked. The buffer layer 140 may be formed on an entire top surface of the substrate 110 to block moisture from invading the organic light-emitting element through the substrate 110. A driving thin-film transistor may be disposed on the buffer layer 140.

The passivation layer 150 is disposed on the buffer layer 140, and the passivation layer 150 protects the data line DL, the reference line REF, the driving voltage line VDD, and the driving thin-film transistor. The passivation layer 150 may be made of an inorganic insulating material such as silicon oxide and silicon nitride, or an organic insulating material such as photoacryl or benzocyclobutene.

The color filters CF_R, CF_B, and CF_G may be disposed on the passivation layer 150. A red color filter CF_R may be located in the red light-emitting area EA_R, a blue color filter CF_B may be located in the blue light-emitting area EA_B, and a green color filter CF_G may be located in the green light-emitting area EA_G. No color filter may be located in the white light-emitting area EA_W. In the white light-emitting area EA_W, white light emitted from the organic light-emitting layer 175 is emitted to the outside through the substrate 110 while a wavelength thereof is maintained.

The overcoat layer 160 covering the color filters CF_R, CF_B, and CF_G is positioned on the passivation layer 150. The overcoat layer 160 may planarize irregularities caused by the color filters CF_R, CF_B, CF_G, and the like. The overcoat layer 160 may be made of an organic-based insulating material such as photoacryl or benzocyclobutene. At a top surface of the overcoat layer 160, the plurality of concave portions RR are formed in each sub-pixel area. The plurality of concave portions RR may be regularly arranged to constitute the micro lens array MLA. Accordingly, light extraction efficiency of each sub-pixel area may be improved. In addition, a portion of the overcoat layer 160 in each of the red light-emitting area EA_R and the white light-emitting area EA_W may include the first and second flat areas NP1 and NP2 in which the concave portions RR are not disposed. I.e. the first and second flat areas NP1 and NP2 are provided on the overcoat layer 160.

The first electrodes 170 may be disposed on the overcoat layer 160 in each of the sub-pixel areas, respectively. The first electrode 170 covers the plurality of concave portions RR in each sub-pixel area. A portion of the first electrode 170 disposed in the red sub-pixel area SP_R may include first flat electrode areas corresponding to the first flat areas NP1, and a portion of the first electrode 170 disposed in the white sub-pixel area SP_W may include second flat electrode area corresponding to the second flat area NP2. The first electrode 170 may be electrically connected to a source electrode or a drain electrode of the driving thin-film transistor in each sub-pixel area.

The bank layer 190 covers an edge of each of the first electrodes 170 so as to define each of the light-emitting areas of the sub-pixel areas. The bank layer 190 covers the concave portions RR disposed in the non-light-emitting area NA. So, the bank layer 190 covers an edge of the first flat areas NP1 in the red sub-pixel area SP_R and the second flat area NP2 of the white sub-pixel area SP_W and/or an edge of the concave portions RR in the blue and green sub-pixel areasSP_B and SP_G.

The organic light-emitting layer 175 and the second electrode 180 are sequentially stacked on the bank layer 190 and the first electrode 170. The organic light-emitting layer 175 may emit white light. The first electrode 170, the organic light-emitting layer 175 and the second electrode 180 constitute an organic light-emitting element.

The pair of the first flat areas NP1 are respectively disposed in both opposing side edges of the opening of the bank layer 190 defining the red light-emitting area EA_R. The first flat areas NP1 may be partially disposed in the red light-emitting area EA_R, and then extend out of the red light-emitting area EA_R, that is, under the bank layer 190 of the non-light-emitting area NA. The pair of the first flat areas NP1 respectively overlap both opposing sidewalls of the opening of the bank layer 190 defining the red light-emitting area EA_R. The second flat area NP2 is disposed in one side of an opening of the bank layer 190 defining the white light-emitting area EA_W. The second flat area NP2 may be partially disposed in the white light-emitting area EA_W, and then extend out of the white light-emitting area EA_W, that is, under the bank layer of the non-light-emitting area NA. The second flat area NP2 overlaps one sidewall of the opening of bank layer 190 defining the white light-emitting area EA_W.

Therefore, according to an embodiment of the present disclosure, the first and second flat areas in which the concave portions are not formed may be included in or provided on the overcoat layer so as to overlap the sidewalls of the openings of the bank layer, respectively. Thus, a gray level at each of the sidewalls of the opening of the bank layer in the photographed optical image is not distorted. Thus, the size of the opening of the bank layer or the distance between the openings may be measured without error.

Further, the first and second flat areas in which the concave portions are not formed may be included in the overcoat layer such that the size of the opening in the bank layer or the distance between the openings may be measured. Thus, the size of the opening in the bank layer or the distance between the openings may be managed to be within a predefined target range. This may prevent decrease in the light extraction efficiency of the display apparatus.

It has been described above that the first flat areas NP1 are disposed in the red sub-pixel area SP_R and the second flat area NP2 are disposed in the white sub-pixel area SP_W. However, the present disclosure is not limited thereto. Positions of the first flat areas NP1 and the second flat area NP2 may be changed based on the sizes of the sub-pixel areas.

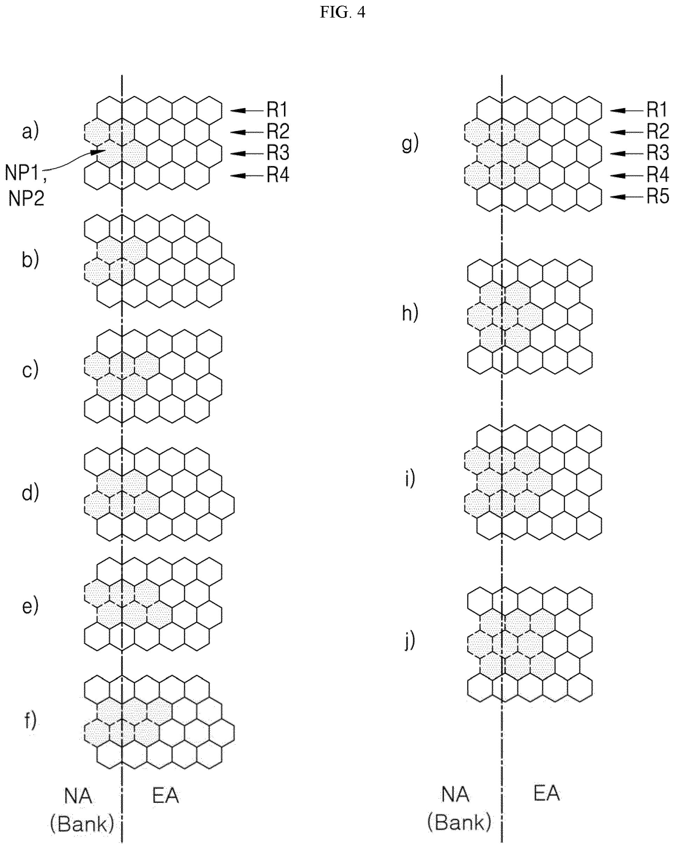

FIG. 4 shows forms of the first and second flat areas NP1 and NP2 according to embodiments of the present disclosure. FIG. 4 shows only the first and second flat areas NP1 and NP2 and some concave portions RR around the first and second flat areas.

Referring to FIG. 4, a plurality of examples of first and second flat areas NP1 and NP2 are illustrated. Fig. 4a illustrates an example having 4 concave portions (or micro lenses) omitted, in particular one and half concave portions (or micro lenses) are omitted in row 2 inside the bank and a full concave portion (or micro lens) is omitted inside the bank in row 3.

Fig. 4b illustrates an example having also 4 concave portions (or micro lenses) omitted, having the edge of the bank in the second row R2 between two concave portions (or micro lenses), whereas in Fig. 4a, the edge of the bank is running in row R2 through an omitted concave portion (or micro lens) and in Fig. 4a in row R3 between two omitted concave portions (or micro lenses). Fig. 4c and 4d illustrate examples having 5 concave portions (or micro lenses) omitted. In fig. 4e and 4f 6 concave portions (or micro lenses) are omitted. Fig. 4g-4j have 7, 8 and 9 concave portions (or micro lenses) omitted.

The number of micro lenses which are omitted at the edge of the sub pixel area depends on the light efficiency reduction which is still acceptable.

As any concave portion (or micro lens) which is missing in the sub pixel area will reduce the light output efficiency, only a small number of concave portions (or micro lenses) will be omitted. This is also the reason why to provide the flat areas only in the red and/or white sub-pixels, as these colors sub-pixels have a larger light-emitting area than the blue or green sub pixel. In other words, omitting concave portions (or micro lenses) in the blue or green sub-pixel will have a more sever effect on the light efficiency than for the red or white sub pixel.

As the openings for the sub-pixels are made by a single mask, it is sufficient to check the dimension of only one sub pixel area, as any misalignment of the mask, which would be detected by taking the photo of the opening will have an effect also to the other openings of bank in the sub pixel areas. So, if after taking the photo, it is detected, that the opening of bank is not within the required tolerances, a rework or adjustment of the opening is required.

The second flat area in the white sub pixel is used to measure the distance between the different openings of the sub pixels, for instance the distance from the edge of white sub pixel to the edge of the red sub pixel.

In Fig. 4 a-f each of the first flat area NP1 and the second flat area NP2 may correspond to two rows R2 and R3 of the plurality of concave portions RR, whereas in Fig. 4g-j the first flat area NP1 and the second flat area NP2 may correspond to three rows R2, R3 and R4 of the plurality of concave portions RR.

Each of the first flat area NP1 and the second flat area NP2 may have an area size equal to or greater than four times of an area size of one concave portion RR. In one example, an area size of each of the first flat area NP1 and the second flat area NP2 may be greater than or equal to a sum of area sizes of four concave portions and may be smaller than or equal to a sum of area sizes of nine concave portions. The first flat area NP1 and the second flat area NP2 may have the same shape and area size as each other. However, the present disclosure is not limited thereto.

In FIG. 4, the shapes and the area sizes of the first flat area NP1 and the second flat area NP2 are illustrated by way of example. However, the present disclosure is not limited thereto.

The display apparatus in which one pixel area includes four sub-pixel areas, that is, the red sub-pixel area SP_R, the green sub-pixel area SP_G, the white sub-pixel area SP_W and blue sub-pixel area SP_B has been described above. However, the present disclosure is not limited thereto. For example, the present disclosure may be applied to a display apparatus in which one pixel area includes three sub-pixel areas, a red sub-pixel area, a green sub-pixel area, and a blue sub-pixel area.

The flat areas NP1 and NP2 are produced by adapting the edge area in the mask which is used for producing the concave portions (or micro lenses). Thus, in the areas which should have no concave portions (or micro lenses), no holes for forming the concave portions (or micro lenses) are formed in the mask.

The photographed optical image for determining the distance between opposing banks is taken before depositing the light emitting layer and the second electrode. Thus, when detecting that the opening in the bank for the sub pixel having the pair of flat areas is out of the tolerances, and adjustment to the opening can be made.

The size of the opening is important to avoid or reduce the rainbow mura effect for bottom emission displays, as the external light is reflected at the cathode which causes the rainbow mura effect. Thus, the opening in the bank should have predetermined size to avoid the reflection from external light.

In case that the opening is out of the tolerances, the adjustment is made by repeating the processes to generate or create the opening of the bank.

The first flat areas should be same. However, slight deviations might be acceptable. Also, the second flat area could have the same form as the first flat area. Having the same area being flat in the red and white sub-pixels makes it easier to precisely determine the opening dimension of the red sub pixel and the distance between the red sub-pixel and the white sub-pixel.

A scope of protection of the present disclosure should be construed by the scope of the claims, and all technical ideas within the scope equivalent thereto should be construed as being included in the scope of the present disclosure. Although the embodiments of the present disclosure have been described in more detail with reference to the accompanying drawings, the present disclosure is not necessarily limited to these embodiments. The present disclosure may be implemented in various modified manners within the scope not departing from the technical idea of the present disclosure. Accordingly, the embodiments disclosed in the present disclosure are not intended to limit the technical idea of the present disclosure, but to describe the present disclosure. The scope of the technical idea of the present disclosure is not limited by the embodiments. Therefore, it should be understood that the embodiments as described above are illustrative and non-limiting in all respects. The scope of protection of the present disclosure should be interpreted by the claims, and all technical ideas within the scope of the present disclosure should be interpreted as being included in the scope of the present disclosure.

## Claims

1. A display apparatus comprising:
a substrate (110) including a plurality of sub-pixel areas (SP_R, SP_B, SP_G, SP_W);
an overcoat layer (160) disposed on the substrate (110) and having a plurality of concave portions (RR) disposed in each of the plurality of sub-pixel areas (SP_R, SP_B, SP_G, SP_W); and
a bank layer (190) disposed on the overcoat layer (160) and having openings defined therein so as to define a light-emitting area (EA_R, EA_B, EA_G, EA_W) of each of the plurality of sub-pixel areas (SP_R, SP_B, SP_G, SP_W),
wherein the plurality of sub-pixel areas (SP_R, SP_B, SP_G, SP_W) include a first sub-pixel area having a first light-emitting area (EA_R),
wherein the overcoat layer (160) has a pair of first flat areas (NP1) at least in the first light-emitting area (EA_R).

2. The display apparatus of claim 1, wherein the first flat areas (NP1) are spaced apart from each other in a first direction (X) in which a gate line (GL) extends and/or in a second direction (Y) in which a data line (DL) extends.

3. The display apparatus of claim 1 or 2, wherein an edge of the bank layer (190) defining the first light emitting area (EA_R) and extending in a second direction is overlapping both the first flat area (NP1) and the concave portions (RR).

4. The display apparatus of claim 1, 2 or 3, wherein the first flat areas (NP1) are respectively disposed at both opposing sides of the first light-emitting area (EA_R).

5. The display apparatus of any one of the preceding claims, wherein each of the first flat areas (NP1) extends out of the first light-emitting area (EA_R) and/or is overlapped by a portion of the bank layer (190).

6. The display apparatus of any one of the preceding claims, wherein each of the first flat areas (NP1) has an area size equal to or greater than 4 times of an area size of one concave portion (RR).

7. The display apparatus of any one of the preceding claims, wherein the plurality of sub-pixel areas include a second sub-pixel area (SP_W) spaced apart from the first sub-pixel area (SP_R) and having a second light-emitting area (EA_W).

8. The display apparatus of claim 7, wherein the overcoat layer (160) has one second flat area (NP2) in the second light-emitting area (EA_W), wherein the concave portions (RR) are absent in the second flat area (EA_W).

9. The display apparatus of claim 8, wherein the second flat area (NP2) extends out of the second light-emitting area (SP_W) so as to overlap a portion of the bank layer (190).

10. The display apparatus of claim 8 or 9, wherein the second flat area (NP2) has an area size equal to or greater than 4 times of an area size of one concave portion (RR).

11. The display apparatus of any one of the preceding claims 8-10, wherein the first flat areas (NP1) and the second flat area (NP2) are located at the same line (L) and/or wherein the same line (L) extends in a first direction (X) in which a gate line (GL) extends.

12. The display apparatus of any one of the preceding claims, wherein the area size of the first sub-pixel area (SP_R) and of the second sub-pixel area (SP_W) are larger than the area size of the third sub-pixel area (SP_B) and of the fourth sub-pixel area (SP_G).

13. The display apparatus of any one of the preceding claims, wherein the concave portions (RR) are absent in each of the first flat areas (NP1).

14. The display apparatus of any one of the preceding claims, wherein another sub-pixel area is located between the first sub-pixel area and the second sub-pixel area, and/or wherein the other sub-pixel area does not have any flat area in a light emitting area and/or the light emitting area of the another sub-pixel area is fully covered by concave portions.

15. The display apparatus of any one of the preceding claims, wherein a pixel includes a red sub-pixel, a blue sub-pixel, a white sub-pixel and a green sub-pixel, wherein the blue sub-pixel and the green sub-pixel don't have any flat area in a light emitting area.
